# EUROPEAN PATENT SPECIFICATION

(11) **EP 1 482 375 B1**
(45) Date of publication and mention of the grant of the patent: **17.09.2014**
(21) Application number: 04253203.6
(22) Date of filing: 28.05.2004
(51) Int. Cl.: G03F 9/00, G03F 7/20

(54) **Lithographic apparatus and device manufacturing method**
Lithographischer Apparat und Verfahren zur Herstellung eines Artikels
Appareil lithographique et méthode de fabrication d'un dispositif

(30) Priority: 30.05.2003 EP 03253419
(43) Date of publication of application: 01.12.2004
(73) Proprietor: ASML Netherlands B.V., 5504 DR Veldhoven (NL)
(72) Inventor: George, Richard Alexander, 5691 HN Son en Breugel (NL); Gui, Gheng-Qun, 5685 AZ Best (NL)
(74) Representative: Broeken, Petrus Henricus Johannes

(56) References cited:
- JP-A- 7 183 214
- US-A- 5 657 130
- US-A- 6 133 986
- US-A1- 2001 045 690
- US-A1- 2002 024 714

## Description

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs), flat panel displays and other devices involving fine structures. In a conventional lithographic apparatus, a patterning means, which is alternatively referred to as a mask or a reticle, may be used to generate a circuit pattern corresponding to an individual layer of the IC (or other device), and this pattern can be imaged onto a target portion (e.g. comprising part of, one or several dies) on a substrate (e.g. a silicon wafer or glass plate) that has a layer of radiation-sensitive material (resist). Instead of a mask, the patterning means may comprise an array of individually controllable elements which serve to generate the circuit pattern.

In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In order to manufacture devices using lithographic techniques, it is typically necessary to form the device from multiple layers. When producing such a device from multiple layers, it is necessary to ensure that, as each layer is created, it is aligned with the previous layers. It has therefore been known to provide alignment marks on a substrate. Before each layer is exposed on the substrate, it is transported to an alignment measuring centre, where the alignment marks are located, allowing a precise determination of the position of the substrate relative to the alignment sensors. By moving the substrate in a controlled manner to the exposure position, a positional correction can be applied to accurately produce the subsequent layer in the correct position on the substrate. Such a system can be used to ensure that the overlay errors are small in comparison to the critical feature size.

However, as the critical feature size continues to diminish, further improvements in the overlay accuracy are required. Furthermore, as the alignment requirements increase, the time taken to locate and inspect the alignment marks increases, reducing the throughput of the apparatus.

US 5,657,130 discloses an exposure apparatus and method, in which a mask and a substrate are scanned in synchronism with each other so that the pattern of the mask may be transferred onto the substrate through a projection optical system. First beams of light are irradiated to least two locations on the mask spaced apart in a direction intersecting the scanning direction of the mask. The reflected light thereof is received, and the positions of the points on the mask to which the beam of light has been irradiated are detected in the direction of the optical axis of the projection optical system. In addition, second beams of light are irradiated to at least two locations on the substrate spaced apart in the scanning direction, and the reflected light thereof is received. The positions of the points on the substrate to which the second beam of light has been irradiated are also detected in the direction of the optical axis of the projection optical system are detected. The posture of at least one of the mask and the substrate is adjusted on the basis of the positions detected with the first and second beams.

JP 7183214 discloses a lithographic system in which a pattern region on a substrate is precisely overlapped with an original plate pattern by changing the projection magnifying power of a projection optical system by shifting a lens of the system in the direction of an optical axis in the scanning step when the pattern region on a wafer is overlapped with a reticle pattern by projecting the pattern of the reticle illuminated by exposure light from a light source on a wafer using the projection optical system to scan the reticle and the wafer on the exposure light and the projection optical system.

It is an object of the present invention to provide a method and apparatus in which the overlay accuracy can be improved without significant loss of throughput of the apparatus.

According to an aspect of the invention there is provided a lithographic apparatus as specified in the claims.

The throughput of the apparatus can be increased because the detector can inspect the complete substrate, or portions of the substrate, representative of the complete substrate, and expose the required pattern on the substrate by scanning the substrate relative to the apparatus in a single pass. This is especially beneficial in the manufacture of Flat Panel Displays, for example, in which the glass substrate being processed may be up to 2m by 2m or more in size.

Such apparatus is also beneficial since the overlap accuracy for each portion of the substrate can be improved. Furthermore, because portions of the substrate can be inspected while the substrate is in the exposure position, errors are not introduced in moving the substrate from an alignment measuring position to the exposure position. Beneficially, therefore, the overlay can take into account not only defects that are introduced into the substrate during the previous processing step but also it can take account of changes that occur during the exposure of that layer. For example, this system can compensate for expansion/contraction of the substrate during the exposure caused by heating of the substrate by the radiation used to expose each layer. Consequently, the overlay accuracy of each part of the substrate is improved. Furthermore, since the substrate does not need to be transported to a separate alignment measuring center, the processing time of the substrate is not significantly increased.

Preferably, by inspecting the portion of the substrate, the detector can determine the position and/or orientation of that portion of the substrate and/or the amount that that portion of the substrate has expanded/contracted relative to a reference state of the substrate. This information can be used to adjust the position of the pattern projected onto the substrate, the magnification of the pattern projected onto the substrate and the best focus image plane.

The position of the detector relative to the projection system may be substantially fixed and known or a position sensor may be provided for monitoring the position of the detector relative to the projection system. Consequently, knowledge of the position of a portion of the substrate relative to the detector may be readily and accurately converted to knowledge of the position of the portion of the substrate relative to the projection system.

In a preferred embodiment, the substrate is moved relative to the projection system and the detector between consecutive exposures, or as a continuous exposure proceeds, and the detector is arranged so that the portions of the substrate that the detector inspects subsequently become the target portions of the substrate that are exposed. The distance the substrate has to move relative to the detector and the projection system is known from the relative positions of the detector and the projection system. Consequently, the detector can inspect a given portion of the substrate shortly before this portion of the substrate is exposed; and the exposure conditions can be adjusted accordingly to optimize the overlay accuracy when that portion of the substrate is being exposed.

Conveniently, the substrate may move at a substantially constant velocity relative to the projection system and the detector over the course of a plurality of exposures or during a continuous exposure. This reduces the requirement for the substrate to be repeatedly accelerated relative to the projection system and the detector, thus reducing the forces that must be applied. It is also, therefore, possible to adjust the position of a pattern projected onto the substrate in a direction parallel to the movement of the substrate relative to the projection system and detector by altering the timing of the exposures and/or altering the timing of patterns being set on the array of individually controllable elements.

The position of the pattern projected onto the substrate may additionally or alternatively be adjusted by physically moving the projection system, the array of individually controllable elements patterning means, the substrate or a combination of these and/or by shifting the position of the pattern produced on the array of individually controllable elements.

The invention may also be applied to apparatus which is made up of a plurality of arrays of individually controllable elements that are set apart from one another. In this case, the controller can independently adjust, for one or more of the patterns produced by the arrays of individually controllable elements, the position of the pattern projected onto the substrate, the magnification of the pattern and/or the best focus image plane. This allows for compensation of any movement between the individual arrays of individually controllable elements and also allows for compensation of a variance of, for example, the distortion of the substrate between the different areas of the substrate onto which the patterns from each of the arrays of individually controllable elements are projected.

In order to facilitate this, the detector may be able to simultaneously inspect alignment marks at a plurality of locations on the substrate, each corresponding to an area on the substrate that will be simultaneously exposed by the plurality of programmable patterning areas.

It will be appreciated that combinations of the configurations discussed above may also be used.

According to a further aspect of the invention, there is provided a device manufacturing method as specified in the claims.

The term "array of individually controllable elements" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. It will be appreciated that, as an alternative, the filter may filter out the diffracted light, leaving the undiffracted light to reach the substrate. An array of diffractive optical MEMS devices can also be used in a corresponding manner. Each diffractive optical MEMS device is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the array of individually controllable elements can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

It should be appreciated that where pre-biasing of features, optical proximity correction features, phase variation techniques and multiple exposure techniques are used, for example, the pattern "displayed" on the array of individually controllable elements may differ substantially from the pattern eventually transferred to a layer of or on the substrate. Similarly, the pattern eventually generated on the substrate may not correspond to the pattern formed at any one instant on the array of individually controllable elements. This may be the case in an arrangement in which the eventual pattern formed on each part of the substrate is built up over a given period of time or a given number of exposures during which the pattern on the array of individually controllable elements and/or the relative position of the substrate changes.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat panel displays, thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multilayer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 408, 355, 365, 248, 193, 157 or 126 nm) and extreme ultra-violet (EUV) radiation (e.g. having a wavelength in the range of 5-20 nm), as well as particle beams, such as ion beams or electron beams.

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables. In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the array of individually controllable elements and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2a, 2b and 2c depict a substrate at three time instances as a layer on the substrate is being exposed;
- Figure 3 depicts an arrangement of an exposure unit used in the apparatus of the present invention;
- Figure 4 depicts a part of an exposure unit as shown in Figure 3;
- Figure 5 depicts the exposure field that may be produced by an exposure system as shown in Figure 3;
- Figure 6 depicts an example of an arrangement of repeating units of features formed on a substrate; and
- Figure 7 depicts an arrangement of a detector unit used in the apparatus of the present invention.

In the Figures, corresponding reference symbols indicate corresponding parts

### EMBODIMENTS

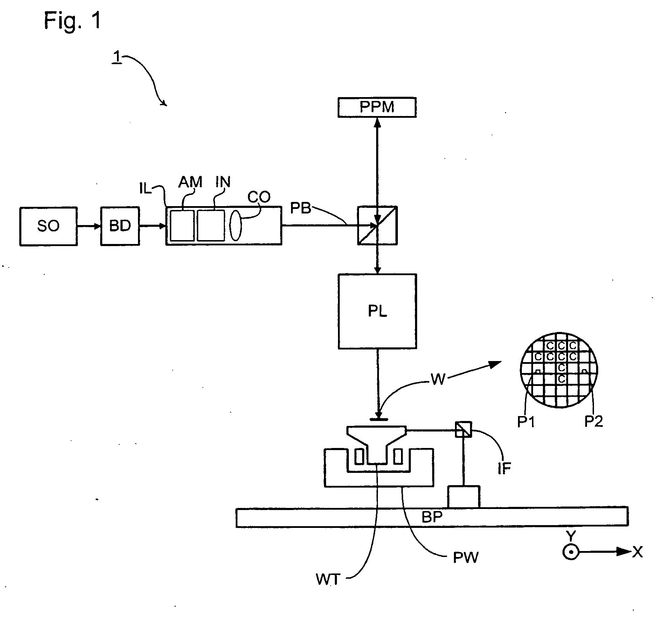

Figure 1 schematically depicts a lithographic projection apparatus according to a particular embodiment of the invention. The apparatus comprises:
- an illumination system (illuminator) IL for providing a projection beam PB of radiation (e.g. UV radiation);
- an array of individually controllable elements PPM (e.g. a programmable mirror array) for applying a pattern to the projection beam; in general the position of the array of individually controllable elements will be fixed relative to item PL; however it may instead be connected to a positioning means for accurately positioning it with respect to item PL;
- a substrate table (e.g. a wafer table) WT for supporting a substrate (*e.g*. a resist-coated wafer) W, and connected to positioning means PW for accurately positioning the substrate with respect to item PL; and
- a projection system ("lens") PL for imaging a pattern imparted to the projection beam PB by the array of individually controllable elements PPM onto a target portion C (*e.g*. comprising one or more dies) of the substrate W; the projection system may image the array of individually controllable elements onto the substrate; alternatively, the projection system may image secondary sources for which the elements of the array of individually controllable elements act as shutters; the projection system may also comprise an array of focusing elements such as a micro lens array (known as an MLA) or a Fresnel lens array, *e.g*. to form the secondary sources and to image microspots onto the substrate.

As here depicted, the apparatus is of a reflective type (*i.e.* has a reflective array of individually controllable elements). However, in general, it may also be of a transmissive type, for example (*i. e.* with a transmissive array of individually controllable elements).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The beam PB subsequently intercepts the array of individually controllable elements PPM. Having been reflected by the array of individually controllable elements PPM, the beam PB passes through the projection system PL, which focuses the beam PB onto a target portion C of the substrate W. With the aid of the positioning means PW (and interferometric measuring means IF), the substrate table WT can be moved accurately, *e.g*. so as to position different target portions C in the path of the beam PB. Where used, the positioning means for the array of individually controllable elements can be used to accurately correct the position of the array of individually controllable elements PPM with respect to the path of the beam PB, *e.g.* during a scan. In general, movement of the object table WT is realized with the aid of a long-stroke module (course positioning) and a short-stroke module (fine positioning), which are not explicitly depicted in Figure 1. A similar system may also be used to position the array of individually controllable elements. It will be appreciated that the projection beam may alternatively/additionally be moveable while the object table and/or the array of individually controllable elements may have a fixed position to provide the required relative movement. As a further alternative, that may be especially applicable in the manufacture of flat panel displays, the position of the substrate table and the projection system may be fixed and the substrate may be arranged to be moved relative to the substrate table. For example, the substrate table may be provided with a system for scanning the substrate across it at a substantially constant velocity.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the array of individually controllable elements imparts an entire pattern to the projection beam, which is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. Scan mode: the array of individually controllable elements is movable in a given direction (the so-called "scan direction", e.g. the Y direction) with a speed v, so that the projection beam PB is caused to scan over the array of individually controllable elements; concurrently, the substrate table WT is simultaneously moved in the same or opposite direction at a speed V = Mv, in which M is the magnification of the lens PL. In scan mode, the maximum size of the exposure field limits the width (in the non-scanning direction) of the target portion in a single dynamic exposure, whereas the length of the scanning motion determines the height (in the scanning direction) of the target portion.
3. Pulse mode: the array of individually controllable elements is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the array of individually controllable elements is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the array of individually controllable elements is updated as the projection beam scans across the substrate and exposes it.

Combinations and/or variations on the above described modes of use or entirely different modes of use may also be employed.

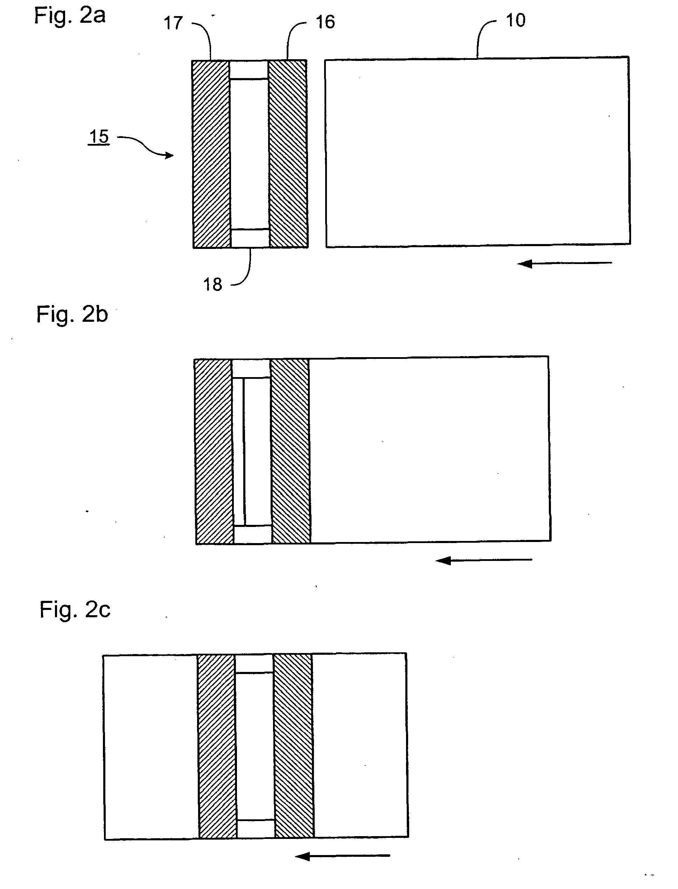

Figures 2a, 2b and 2c illustrate an apparatus according to the present invention. An exposure and alignment module 17 is provided in a fixed location and a substrate 10 is scanned beneath it. Figure 2a depicts the situation immediately before the substrate reaches the exposure and alignment module 15; Figure 2b depicts the situation as the substrate begins to scan beneath the exposure and alignment module; and Figure 2c depicts the situation as the substrate continues to scan beneath the exposure and alignment module 15.

The exposure and alignment module 15 is comprised of a detector unit 16 and an exposure unit 17. The detector unit 16 and exposure unit 17 are connected by means of a reference frame 18 that ensures that the relative position of the exposure unit 17 to the detector unit 16 is fixed. The reference frame 18 may be formed from a material having very low thermal expansion to ensure that the relative positions are stable. The relative position can then be accurately determined by prior calibration. As the substrate is scanned beneath the exposure and alignment module, the detector unit 16 inspects alignment marks on the substrate 10. The information from inspecting the alignment marks is used to accurately determine the position of the substrate in the scan direction, in the transverse direction (i.e. within the plane of the substrate and perpendicular to the scan direction) and perpendicular to the substrate. Furthermore, the alignment marks may be used to ascertain the orientation of the substrate in all three degrees of rotational freedom. The detector unit 16 also inspects the alignment marks to determine the extent of any thermal expansion/contraction of the substrate.

As the substrate 10 scans beneath the exposure and alignment unit 15, each part of the substrate passes first under the detector unit 16 and then under the exposure unit 17. Consequently, the linear position, orientation and expansion information, determined by the detector unit 16, for each portion of the substrate 10 can be transferred to the exposure unit 17 so that the exposure conditions for that portion of the substrate can be optimized when it is exposed as it passes underneath the exposure unit 17. In particular, the position of the pattern projected onto the portion of the substrate can be adjusted for errors in the position of the portion of the substrate in the scan and transverse directions; the best focus image plane can be adjusted for errors in the position of that portion of the substrate in the direction perpendicular to the plane of the substrate; and magnification corrections can be made to correct for any thermal expansion/contraction of that portion of the substrate. In an apparatus for the manufacture of flat panel displays, for example, the detector unit 16 may be positioned 30cm in advance of the exposure unit 17 (from the point of view of the advancing substrate). The scan speed of the substrate relative to the detector unit and exposure unit may be 50mm per second. Consequently the apparatus has 6 seconds in between inspecting a portion of the substrate using the detector unit and illuminating the same portion with the exposure unit. This is sufficient time for the data from the detector unit to be used to adjust the exposure settings, as required, in the exposure unit.

Alignment marks on each portion of the substrate are inspected, allowing continuous corrections to be made. Consequently, overlay errors can be reduced even when there is local deformation of the substrate. Furthermore, the time difference between inspecting the alignment marks and the substrate and exposing the pattern on that part of the substrate is only limited by the separation of the detector unit 16 and the exposure unit 17 and the scanning speed of the substrate. This is in contrast to presently known apparatus in which the substrate is first scanned in its entirety for alignment marks and then scanned in its entirety to expose the pattern. This results in a large time difference between a given portion of the substrate being inspected for alignment marks and that portion being exposed. During this time, additional deformations may be introduced which will result in overlay errors. For example, as the substrate is exposed, the radiation projected onto the substrate increases its temperature. This temperature increase results in a thermal expansion of the substrate. In known systems, this thermal expansion during exposure cannot be accounted for by inspecting alignment marks in a process that is separate to the exposure. In the present invention, however, this expansion is accounted for since the alignment marks are inspected as the exposure takes place. It is especially important for flat-panel display lithography which may be used to image soda-lime glass plates up to two metres long. For such a plate, the expansion would be approximately 8 µm per 1°C temperature change. Therefore, to provide a required overlay accuracy of 0.35 µm without inspecting alignment marks during exposure, the temperature of the substrate would need to be controlled to ± 0.05°C over the entire plate. This would require complicated thermal control.

Furthermore, since the present invention does not require a separate process for inspecting the alignment marks on the substrate, the processing time for each substrate is greatly reduced.

The alignment marks on the substrate may be: alignment gratings parallel to both the scan direction and the transverse direction; chevron alignment marks as used; or image recognition via TV imaging. A sequence of alignment marks may be arranged in one or more rows parallel to the direction in which the substrate is scanned relative to the detector unit 16 and distributed over the length of the substrate. Preferably at least two such rows of alignment marks are provided on the substrate. In each case, known detection optic systems, appropriate for the alignment marks used, are provided in the detector unit 16.

In a preferred arrangement, dedicated alignment marks are not provided on the substrate. Instead, the detector unit is provided with one or more sensors that can detect the pattern of the features that have been formed on the substrate in previous processing steps. Such sensors may be cameras connected to controllers that run pattern recognition algorithms. This arrangment is beneficial because a dedicated alignment mark represents a portion of the substrate that cannot be used for a feature of the device being formed on the substrate. Therefore, by using features of the device itself, a greater portion of the substrate can be used for functioning components of the device. This is especially useful in the formation of flat panel displays, for example, because an alignment mark may be approximately the same size as a pixel of the display being formed. Therefore if an alignment mark were required within the display, this would result in the absence of a pixel at that location in the finished device, which would clearly be unacceptable. The use of features formed in previous layer is also advantageous because when a new layer is being formed on a device on a substrate, it is essential to ensure that it is correctly overlaid with the previous layers of the device that have been formed. By directly measuring the position of the features of the earlier layers formed on the substrate, one can ensure that the next layer is correctly overlaid. If, as described, the detector unit inspects functional features of the device being formed instead of dedicated alignment marks, it may be necessary around the edges of the device being formed to include dummy features (i.e. those that appear similar to the functional features) in order to ensure that the alignment is correct when forming the functional features at the edge of the device.

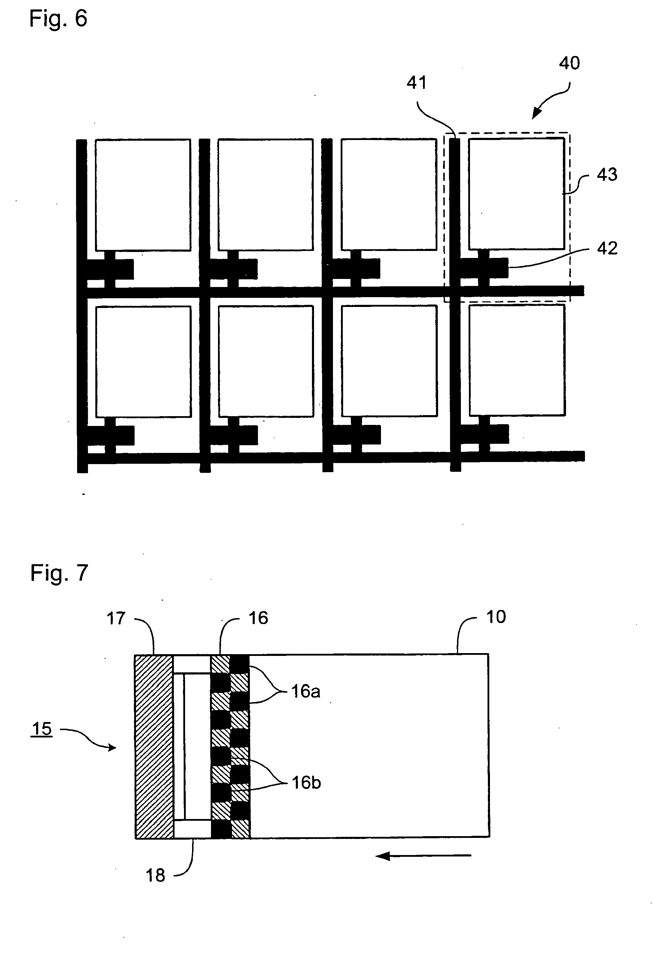

Figure 6 schematically represents a portion of the feature pattern that may be formed on a substrate during the manufacture of a flat panel display. As shown, the overall pattern is made up of a plurality of repeating units 40, comprising control lines 41, a thin film transistor 42 and the pixel itself 43. Therefore an image recognition system may be used to identify the repeating units and accurately measure the position of the features. Advantageously, a self-learning image recognition system may be used. As noted, the patterns are highly repeatable. Therefore the image recognition detector may be used for the fine measurements of the position of the features on the substrate and a separate system may be used for coarse position measurement because there may be no distinguishable difference between the repeated units on different parts of the substrate. For example, a ruler may be provided on the substrate, namely a series of marks to indicate the position along the length of the substrate. The ruler may, for example, only be provided along the edge of the substrate because it is only being used for the coarse measurement of the position of the features of the device formed on the substrate. In other words, the ruler need not be formed at a position on the substrate where it would be desirable to form features of the device to be formed on the substrate. Alternatively, or additionally, the image recognition sensor may be able to perform the coarse position measurement by storing information as the substrate scans relative to the detector unit. For example, the detector unit may count the number of repeating units of the pattern of preceding layers formed on the substrate that have already scanned passed the detector unit. This count data can therefore be used to determine which of the repeating units is subsequently identified by the pattern recognition detector.

The position of the pattern that is projected onto the substrate may be moved by several means. Firstly, the position of the substrate 10 may be corrected as it scans beneath the exposure and alignment unit 15. For instance, the substrate table may be mounted on a long-stroke module that provides the scanning motion; with a short-stroke module mounted between the long-stroke module and the substrate table to provide the corrective movement. Alternatively, the exposure and alignment unit 15 or, at least, the exposure unit 17 (or a part thereof) may be mounted on an actuator to provide corrective movements in order to project the pattern onto the correct portion of the substrate. A further option would be to move the pattern formed on the array of individually controllable elements electronically (namely to adjust the data provided to the array of individually controllable elements such that the pattern appears shifted on the array of individually controllable elements). The position of the pattern projected onto the substrate in a direction parallel to the scanning direction can also be adjusted by controlling the timing of the exposure of the pattern as the substrate is scanned beneath the exposure unit 17 or adjusting the timing of a pattern being set on the array of individually controllable elements if, for example, the apparatus is used in a continuous scan mode. Of course, a combination of the above-described techniques may also be used.

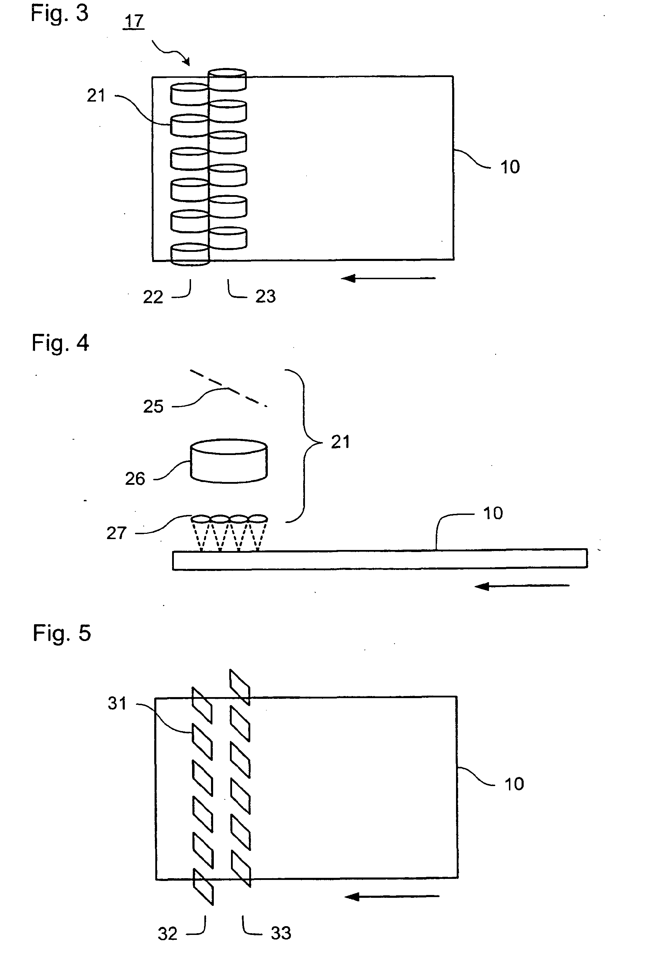

Figure 3 depicts a detail of an exposure unit 17 that may be used with the present invention. The exposure unit is comprised of a plurality of light engines 21 that are each capable of producing a patterned beam of radiation and projecting it onto the substrate 10. As shown in Figure 3, the light engines 21 are arranged in two arrays 22, 23 perpendicular to the scan direction of the substrate. Figure 4 shows a detail of a light engine 21. The light engine is comprised of an array of individually controllable elements 25, projection optics 26 and a micro-lens array 27. Two or more light engines 21 may share a common radiation source or each may be provided with an independent radiation source. It will also be appreciated that although, as shown, the light engine uses a micro-lens array, the array of individually controllable elements 25 may be wholly imaged onto the substrate 10.

As shown in Figure 5, the arrays 22, 23 of light engines 21 produce corresponding arrays 32, 33 of pattern images 31 on the substrate 10. In each array 22, 23 of light engines 21, space is provided between the light engines. This space may be used to provide ancillary services for the light engines, such as cooling or to provide space for radiation sources. Consequently, there are gaps in the arrays 32, 33 of patterned images 31 projected onto the substrate. The arrays 22, 23 of light engines are arranged such that the second array 32 of patterned images 31 projected onto the substrate by the second array of light engines 22 coincide with the gaps in the first array 33 of patterned images projected onto the substrate by the first array 23 of light engines after the substrate has moved a given distance. Consequently, a complete strip of the substrate across the transverse direction can be exposed notwithstanding the gap between the light engines 21. As shown in Figures 3 and 5, there are two arrays of light engines 21. It will be appreciated, however, that additional arrays can be provided in the exposure unit 17, for example to allow for larger gaps between the light engines 21 or to allow each part of the substrate to receive more than one exposure within a single scan.

In a preferred embodiment, each of the adjustments that are made to the pattern projected onto the substrate in response to information from the detector unit 16 can be made independently by each of the light engines. This may be effected by providing individual actuators to control the position of each of the light engines 21, by providing magnification control and best focus image plane control in the projection optics 26 and/or the micro lens arrays of each of the light engines 21 and/or by providing separate data control for each of the light engines so that electronic corrections can be applied independently. By this means it is possible to compensate for local distortions and deformations across the substrate. It may, however, be desirable to also provide global compensation means (i.e. compensation means that affect the pattern produced by all of the light engines) to compensate for, for example, positional errors of the substrate as a whole.

Where the light engines are not mounted on separate actuators, the micro-lens arrays of all of the light engines may be mounted on a single reference frame that, preferably, has a very low thermal expansion. However, if required, the position of each micro-lens array relative to the reference frame may be adjustable. Similarly, the array of individually controllable elements of all of the light engines may be mounted on a separate reference frame and the position of each relative to the reference frame may be adjustable. Consequently, the relative positions of the patterns produced by the light engines can be measured and calibrated.

The magnification of each light engine can be adjusted by changing the position of the array of individually controllable elements to compensate for any expansion/contraction of the substrate or by any other suitable optical method. Alternatively or additionally, the magnification of the pattern projected onto the substrate can be adjusted by electronically changing the pattern applied to the array of individually controllable elements. As before, this may be performed independently for each light engine and/or globally for all light engines (for example, by adjusting the position of the reference frame on which all of the arrays of individually controllable elements are mounted). Preferably, the magnification control range is ± 15 ppm.

In a variant of the above-described embodiment, the detector unit 16 and the exposure unit 17 may not be rigidly connected to one another or may be connected by a frame that is subject to thermal expansion/contraction. In this case, a position sensor must be provided to monitor the position of the exposure unit 17 relative to the detection unit 16. Thus the relative position remains known, even if it is not fixed.

As shown in Figure 7, the detector unit 16 is preferably comprised of a plurality of sensors 16a,16b such that the alignment marks and/or features of previously formed layers on the substrate can be inspected across the full width of the substrate. Consequently, variations across the width of the substrate in the deformation of the substrate and/or the alignment of features already formed on the substrate can be taken into account when setting the exposure conditions in the exposure unit 17. As shown in Figure 7, the arrangement of the sensors in 16a,16b in the detector unit 16 may be arranged in a manner corresponding to that of the light engines in the exposure unit 17. For example, the sensors may be arranged in a first array of sensors 16a and second array of sensors 16b, each array comprising a set of spaced apart sensors. Therefore, although the full width of the substrate 10 is inspected, clearance can be provided around of each of the sensors 16a,16b for control lines, services, etc.

It will be appreciated that in an arrangement as described above, each sensor 16a,16b may be arranged such that it is associated with a given one of the light engines 21, namely each portion of the substrate that is inspected by a given sensor is subsequently exposed using the associated light engine. It will also be appreciated that this arrangement need not be limited to two rows of sensors as shown in Figure 7 but may be configured with any number of rows, as convenient. In addition, the detector unit 16 may be arranged such that it does not inspect each part of the substrate 10. For example, a row of sensors may be arranged across the width of the detection unit 16 but set apart from one another. In this case, the sensors are arranged to measure the position and/or orientation of the substrate and/or the features formed on the substrate at a plurality of locations that are set apart from one another. The exposure condition can therefore be set for these areas on the substrate directly from the measurements from the sensors. For the areas in between, which have not been inspected by sensors, the exposure conditions may be set by interpolating the data from two or more sensors that have inspected the surrounding portions of the substrate.

It is further to be appreciated that although the invention has been primarily described above in relation to an apparatus that uses the pulse mode (described above), in which the substrate is moved at an essentially constant speed and the exposures are pulsed, it will be appreciated that the invention may equally be applied to apparatus that operates in a stepped mode (described above) and apparatus that operates in a scan mode (described above). Furthermore, although the invention refers to the use of an array of individually controllable elements for patterning the radiation beam, it will be appreciated that the invention may be equally be applied to apparatus using a conventional fixed mask to pattern the projection beam. In this case, it may be used, for example, with an apparatus operating in scan mode: the detector could be located between the mask and the substrate and arranged to precede the patterned projection beam as it scans across the substrate. Finally, although the invention has been described in terms of the substrate being moved below the exposure and alignment unit, it will be readily appreciated that the absolute positions described are not essential to the invention nor is it essential that a given part of the apparatus is fixed: it is only necessary that the substrate move relative to the exposure and alignment unit.

While specific embodiments of the invention have been described above, it will be appreciated that the invention may be practiced otherwise than as described. The description is not intended to limit the invention.

## Claims

1. A lithographic apparatus comprising:
- patterning means;
- a substrate table (WT) for supporting a substrate (W,10);
- a projection system (PL) for projecting a patterned beam from the patterning means onto a target portion (C) of the substrate (W,10);
- a detector (16) for inspecting the substrate (W,10) while the substrate (W,10) is in a position for the projection system (PL) to project the patterned beam onto the substrate (W,10); and
- a controller for adjusting the position of the pattern projected onto the substrate (W,10) relative to the substrate (W,10) in response to information from the detector (16);
wherein the detector (16) has a plurality of sensors (16a,16b) for simultaneously inspecting a plurality of portions of the substrate (W,10) across the full width of the substrate (W,10); and the patterning means and projection system (PL) are arranged to expose the full width of the substrate (W,10); whereby the substrate (W,10) can be inspected and exposed in a single pass of the substrate (W,10) relative to the apparatus,
wherein said patterning means comprises an array of individually controllable elements (PPM,25),
wherein the position of a pattern projected onto the substrate (W,10) is adjusted by at least one of adjusting the timing of a pattern being set on the array of individually controllable elements (PPM,25) and electronically adjusting the position of the pattern set on the array of individually controllable elements (PPM,25).

2. A lithographic projection apparatus according to claim 1, wherein the detector (16) determines, from inspecting the portion of the substrate (W,10), the position of said portion of the substrate relative to the detector (16) in one or more directions.

3. A lithographic projection apparatus according to any one of the preceding claims, wherein the position of the detector (16) relative to the projection system (PL) is substantially fixed and is known.

4. A lithographic projection apparatus according to any one of the preceding claims, further comprising a position sensor for monitoring the position of the detector (16) relative to the projection system (PL).

5. A lithographic projection apparatus according to any preceding claims, further comprising positioning means for moving the substrate (W,10) relative to the projection system (PL) and the detector (16) to consecutively expose different areas of the substrate;
wherein the detector (16) is arranged to inspect the given area of the substrate before that area is exposed.

6. A lithographic projection apparatus according to any one of the preceding claims, wherein the apparatus is configured to move the substrate (W,10) at a substantially constant velocity relative to the projection system (PL) and the detector (16) throughout a sequence of a plurality of exposures or during an exposure.

7. A lithographic projection apparatus according any one of the preceding claims, wherein the position of a pattern projected onto the substrate (W,10) is adjusted by at least one of physically moving the projection system (PL) and/or the patterning means and/or the substrate (W,10) and adjusting the timing of the exposure.

8. A lithographic projection apparatus according to any one of the preceding claims, wherein the patterning means comprises a plurality of arrays of individually controllable elements (PPM,25) set apart from one another; and
the controller can independently adjust the position of the pattern projected onto the substrate (W,10) corresponding to at least one of the arrays of individually controllable elements (PPM,25).

9. A lithographic projection apparatus according to any one of the preceding claims, wherein the detector (16) has a plurality of sensors (16a,16b) for simultaneously inspecting a plurality of portions of the substrate (W,10) that are set apart from one another.

10. A lithographic projection apparatus according to any one of the preceding claims, wherein the detector (16) inspects alignment marks on the substrate (W,10).

11. A lithographic projection apparatus according to any one of the preceding claims, wherein the detector (16) inspects features of the device being formed on the substrate produced by previous processing steps.

12. A device manufacturing method comprising:
- providing a substrate (W,10);
- projecting a patterned beam of radiation from patterning means onto a target portion (C) of the substrate (W,10),
- using a detector (16) to inspect a portion of the substrate (W,10) while the substrate (W,10) is in a position for the projection system (PL) to project the patterned beam onto the substrate (W,10); and
- adjusting the position of the pattern projected onto the substrate (W,10) relative to the substrate (W,10) in response to information from the detector (16);
wherein the detector (16) has a plurality of sensors (16a,16b) for simultaneously inspecting a plurality of portions of the substrate (W,10) across the full width of the substrate (W,10); and the patterning means and projection system (PL) are arranged to expose the full width of the substrate (W,10); and
the method further comprises inspecting the substrate (W,10) and exposing a pattern on the substrate (W,10) in a single pass of the substrate (W,10) relative to the apparatus,
wherein said patterning means comprises an array of individually controllable elements (PPM,25),
wherein the position of a pattern projected onto the substrate (W,10) is adjusted by at least one of adjusting the timing of a pattern being set on the array of individually controllable elements (PPM,25) and electronically adjusting the position of the pattern set on the array of individually controllable elements (PPM,25).

## Patentansprüche

1. Ein lithographisches Gerät, das Folgendes beinhaltet:
- ein Musteraufbringungsmittel;
- einen Substrattisch (WT) zum Stützen eines Substrats (W, 10);
- ein Projektionssystem (PL) zum Projizieren eines gemusterten Strahls von dem Musteraufbringungsmittel auf einen Zielabschnitt (C) des Substrats (W, 10);
- einen Detektor (16) zum Kontrollieren des Substrats (W, 10), während sich das Substrat (W, 10) in einer Position befindet, in der das Projektionssystem (PL) den gemusterten Strahl auf das Substrat (W, 10) projiziert; und
- eine Steuereinheit zum Anpassen der Position des auf das Substrat (W, 10) projizierten Musters relativ zu dem Substrat (W, 10) als Reaktion auf Informationen von dem Detektor (16);
wobei der Detektor (16) eine Vielzahl von Sensoren (16a, 16b) zum gleichzeitigen Kontrollieren einer Vielzahl von Abschnitten des Substrats (W, 10) über die volle Breite des Substrats (W, 10) aufweist; und das Musteraufbringungsmittel und das Projektionssystem (PL) eingerichtet sind, um die volle Breite des Substrats (W, 10) zu belichten; wodurch das Substrat (W, 10) in einem einzigen Durchlauf des Substrats (W, 10) relativ zu dem Gerät kontrolliert und belichtet werden kann,
wobei das Musteraufbringungsmittel eine Anordnung individuell steuerbarer Elemente (PPM, 25) beinhaltet,
wobei die Position eines auf das Substrat (W, 10) projizierten Musters durch mindestens eines von dem Anpassen der Zeitsteuerung eines Musters, das auf der Anordnung individuell steuerbarer Elemente (PPM, 25) eingestellt wird, und dem elektronischen Anpassen der Position des auf der Anordnung individuell steuerbarer Elemente (PPM, 25) eingestellten Musters angepasst wird.

2. Lithographisches Projektionsgerät gemäß Anspruch 1, wobei der Detektor (16) aus dem Kontrollieren des Abschnitts des Substrats (W, 10) die Position des Abschnitts des Substrats relativ zu dem Detektor (16) in einer oder mehreren Richtungen bestimmt.

3. Lithographisches Projektionsgerät gemäß einem der vorhergehenden Ansprüche, wobei die Position des Detektors (16) relativ zu dem Projektionssystem (PL) im Wesentlichen fest und bekannt ist.

4. Lithographisches Projektionsgerät gemäß einem der vorhergehenden Ansprüche, das ferner einen Positionssensor beinhaltet, um die Position des Detektors (16) relativ zu dem Projektionssystem (PL) zu überwachen.

5. Lithographisches Projektionsgerät gemäß einem der vorhergehenden Ansprüche, das ferner ein Positionierungsmittel beinhaltet, um das Substrat (W, 10) relativ zu dem Projektionssystem (PL) und dem Detektor (16) zu bewegen, um nacheinander unterschiedliche Bereiche des Substrats zu belichten;
wobei der Detektor (16) eingerichtet ist, um den gegebenen Bereich des Substrats zu kontrollieren, bevor dieser Bereich belichtet wird.

6. Lithographisches Projektionsgerät gemäß einem der vorhergehenden Ansprüche, wobei das Gerät konfiguriert ist, um das Substrat (W, 10) durch eine Abfolge einer Vielzahl von Belichtungen oder während einer Belichtung mit einer im Wesentlichen konstanten Geschwindigkeit relativ zu dem Projektionssystem (PL) und dem Detektor (16) zu bewegen.

7. Lithographisches Projektionsgerät gemäß einem der vorhergehenden Ansprüche, wobei die Position eines auf das Substrat (W, 10) projizierten Musters durch mindestens eines von dem physischen Bewegen des Projektionssystems (PL) und/oder des Musteraufbringungsmittels und/oder des Substrats (W, 10) und dem Anpassen der Zeitsteuerung der Belichtung angepasst wird.

8. Lithographisches Projektionsgerät gemäß einem der vorhergehenden Ansprüche, wobei das Musteraufbringungsmittel eine Vielzahl von Anordnungen individuell steuerbarer Elemente (PPM, 25), die voneinander getrennt sind, beinhaltet; und die Steuereinheit die Position des auf das Substrat (W, 10) projizierten Musters, das mindestens einer der Anordnungen individuell steuerbarer Elemente (PPM, 25) entspricht, unabhängig anpassen kann.

9. Lithographisches Projektionsgerät gemäß einem der vorhergehenden Ansprüche, wobei der Detektor (16) eine Vielzahl von Sensoren (16a, 16b) aufweist, um eine Vielzahl von Abschnitten des Substrats (W, 10), die voneinander getrennt sind, gleichzeitig zu kontrollieren.

10. Lithographisches Projektionsgerät gemäß einem der vorhergehenden Ansprüche, wobei der Detektor (16) Justiermarken auf dem Substrat (W, 10) kontrolliert.

11. Lithographisches Projektionsgerät gemäß einem der vorhergehenden Ansprüche, wobei der Detektor (16) durch vorhergehende Verarbeitungsschritte geschaffene Merkmale der Vorrichtung, die auf dem Substrat gebildet wird, kontrolliert.

12. Ein Verfahren zum Herstellen einer Vorrichtung, das Folgendes beinhaltet:
- Bereitstellen eines Substrats (W, 10);
- Projizieren eines gemusterten Strahls aus Strahlung von einem Musteraufbringungsmittel auf einen Zielabschnitt (C) des Substrats (W, 10);
- Verwenden eines Detektors (16) zum Kontrollieren eines Abschnitts des Substrats (W, 10), während sich das Substrat (W, 10) in einer Position befindet, in der das Projektionssystem (PL) den gemusterten Strahl auf das Substrat (W, 10) projiziert; und
- Anpassen der Position des auf das Substrat (W, 10) projizierten Musters relativ zu dem Substrat (W, 10) als Reaktion auf Informationen von dem Detektor (16);
wobei der Detektor (16) eine Vielzahl von Sensoren (16a, 16b) zum gleichzeitigen Kontrollieren einer Vielzahl von Abschnitten des Substrats (W, 10) über die volle Breite des Substrats (W, 10) aufweist; und das Musteraufbringungsmittel und das Projektionssystem (PL) eingerichtet sind, um die volle Breite des Substrats (W, 10) zu belichten; und
das Verfahren ferner das Kontrollieren des Substrats (W, 10) und das Belichten eines Musters auf dem Substrat (W, 10) in einem einzigen Durchlauf des Substrats (W, 10) relativ zu dem Gerät beinhaltet,
wobei das Musteraufbringungsmittel eine Anordnung individuell steuerbarer Elemente (PPM, 25) beinhaltet,
wobei die Position eines auf das Substrat (W, 10) projizierten Musters durch mindestens eines von dem Anpassen der Zeitsteuerung eines Musters, das auf der Anordnung individuell steuerbarer Elemente (PPM, 25) eingestellt wird, und dem elektronischen Anpassen der Position des auf der Anordnung individuell steuerbarer Elemente (PPM, 25) eingestellten Musters angepasst wird.

## Revendications

1. Un appareil lithographique comprenant :
- un moyen pour conformer selon un motif ;
- une table porte-substrat (WT) pour supporter un substrat (W, 10) ;
- un système de projection (PL) pour projeter un faisceau à motif provenant du moyen pour conformer selon un motif sur une portion cible (C) du substrat (W, 10) ;
- un détecteur (16) pour inspecter le substrat (W, 10) tandis que le substrat (W, 10) est dans une position pour que le système de projection (PL) projette le faisceau à motif sur le substrat (W, 10) ; et
- un organe de commande pour ajuster la position du motif projeté sur le substrat (W, 10) relativement au substrat (W, 10) en réponse à des informations provenant du détecteur (16) ;
dans lequel le détecteur (16) possède une pluralité de capteurs (16a, 16b) pour inspecter simultanément une pluralité de portions du substrat (W, 10) sur la pleine largeur du substrat (W, 10) ; et le moyen pour conformer selon un motif et le système de projection (PL) sont arrangés pour exposer la pleine largeur du substrat (W, 10) ; grâce à quoi le substrat (W, 10) peut être inspecté et exposé en un seul passage du substrat (W, 10) relativement à l'appareil,
dans lequel ledit moyen pour conformer selon un motif comprend une matrice d'éléments pouvant être commandés individuellement (PPM, 25),
dans lequel la position d'un motif projeté sur le substrat (W, 10) est ajustée au moins soit en ajustant le choix du moment où un motif est défini sur la matrice d'éléments pouvant être commandés individuellement (PPM, 25), soit en ajustant électroniquement la position du motif défini sur la matrice d'éléments pouvant être commandés individuellement (PPM, 25).

2. Un appareil de projection lithographique selon la revendication 1, dans lequel le détecteur (16) détermine, d'après l'inspection de la portion du substrat (W, 10), la position de ladite portion du substrat relativement au détecteur (16) dans une ou plusieurs directions.

3. Un appareil de projection lithographique selon l'une quelconque des revendications précédentes, dans lequel la position du détecteur (16) relativement au système de projection (PL) est substantiellement fixe et est connue.

4. Un appareil de projection lithographique selon l'une quelconque des revendications précédentes, comprenant en sus un capteur de position pour surveiller la position du détecteur (16) relativement au système de projection (PL).

5. Un appareil de projection lithographique selon n'importe quelles revendications précédentes, comprenant en sus un moyen de positionnement pour déplacer le substrat (W, 10) relativement au système de projection (PL) et au détecteur (16) afin d'exposer consécutivement différentes zones du substrat ;
dans lequel le détecteur (16) est arrangé afin d'inspecter la zone donnée du substrat avant que cette zone ne soit exposée.

6. Un appareil de projection lithographique selon l'une quelconque des revendications précédentes, l'appareil étant configuré afin de déplacer le substrat (W, 10) à une vitesse substantiellement constante relativement au système de projection (PL) et au détecteur (16) tout au long d'une séquence d'une pluralité d'expositions ou au cours d'une exposition.

7. Un appareil de projection lithographique selon l'une quelconque des revendications précédentes, dans lequel la position d'un motif projeté sur le substrat (W, 10) est ajustée au moins soit en déplaçant physiquement le système de projection (PL) et/ou le moyen pour conformer selon un motif et/ou le substrat (W, 10), soit en ajustant le choix du moment de l'exposition.

8. Un appareil de projection lithographique selon l'une quelconque des revendications précédentes, dans lequel le moyen pour conformer selon un motif comprend une pluralité de matrices d'éléments pouvant être commandés individuellement (PPM, 25) placées à l'écart les unes des autres ; et
l'organe de commande peut ajuster de manière indépendante la position du motif projeté sur le substrat (W, 10) correspondant à au moins l'une des matrices d'éléments pouvant être commandés individuellement (PPM, 25).

9. Un appareil de projection lithographique selon l'une quelconque des revendications précédentes, dans lequel le détecteur (16) possède une pluralité de capteurs (16a, 16b) pour inspecter simultanément une pluralité de portions du substrat (W, 10) qui sont placées à l'écart les unes des autres.

10. Un appareil de projection lithographique selon l'une quelconque des revendications précédentes, dans lequel le détecteur (16) inspecte des repères d'alignement sur le substrat (W, 10).

11. Un appareil de projection lithographique selon l'une quelconque des revendications précédentes, dans lequel le détecteur (16) inspecte des caractéristiques du dispositif qui sont formées sur le substrat, produites par des étapes de traitement précédentes.

12. Un procédé de fabrication de dispositif comprenant le fait de :
- fournir un substrat (W, 10) ;
- projeter un faisceau de rayonnement à motif provenant d'un moyen pour conformer selon un motif sur une portion cible (C) du substrat (W, 10),
- utiliser un détecteur (16) afin d'inspecter une portion du substrat (W, 10) tandis que le substrat (W, 10) est dans une position pour que le système de projection (PL) projette le faisceau à motif sur le substrat (W, 10) ; et
- ajuster la position du motif projeté sur le substrat (W, 10) relativement au substrat (W, 10) en réponse à des informations provenant du détecteur (16) ;
dans lequel le détecteur (16) possède une pluralité de capteurs (16a, 16b) pour inspecter simultanément une pluralité de portions du substrat (W, 10) sur la pleine largeur du substrat (W, 10) ; et le moyen pour conformer selon un motif et le système de projection (PL) sont arrangés afin d'exposer la pleine largeur du substrat (W, 10) ; et le procédé comprend en sus le fait d'inspecter le substrat (W, 10) et d'exposer un motif sur le substrat (W, 10) en un seul passage du substrat (W, 10) relativement à l'appareil, dans lequel ledit moyen pour conformer selon un motif comprend une matrice d'éléments pouvant être commandés individuellement (PPM, 25),
dans lequel la position d'un motif projeté sur le substrat (W, 10) est ajustée au moins soit en ajustant le choix du moment où un motif est défini sur la matrice d'éléments pouvant être commandés individuellement (PPM, 25), soit en ajustant électroniquement la position du motif défini sur la matrice d'éléments pouvant être commandés individuellement (PPM, 25).
